# EUROPÄISCHE PATENTSCHRIFT

(11) **EP 1 648 775 B1**
(45) Veröffentlichungstag und Bekanntmachung des Hinweises auf die Patenterteilung: **08.08.2007**
(21) Anmeldenummer: 04763203.9
(22) Anmeldetag: 14.07.2004
(51) Int. Cl.: B65B 9/02, B65B 61/02

(54) **WAFERFIXIERUNG UND -KENNZEICHNUNG**
WAFER FIXING AND MARKING
FIXATION ET MARQUAGE DE PLAQUES

(30) Priorität: 25.07.2003 US 490080 P
(43) Veröffentlichungstag der Anmeldung: 26.04.2006
(73) Patentinhaber: LTS LOHMANN Therapie-Systeme AG, 56626 Andernach (DE)
(72) Erfinder: SCHÄFER, Wolfgang, Madison, NJ 07940 (US)
(74) Vertreter: Schmidt, Werner
(86) Internationale Anmeldenummer: PCT/EP2004/007749
(87) Internationale Veröffentlichungsnummer: WO 2005/012097

(56) Entgegenhaltungen:
- WO-A-99/35051
- DE-A- 10 144 287
- US-B1- 6 467 621

## Beschreibung

Die Erfindung betrifft ein Verfahren zur automatisierten Einzelverpackung blatt- oder folienartiger Materialien, die aus mindestens einer Materialschicht bestehen, in eine Verpackungseinheit mit kennzeichentragendem Inhalt. Ein derartiges Verfahren ist aus der DE-A-10144287 bekannt.

Blatt- oder folienartige Materialien werden beispielsweise in der Pharmazie als Träger pharmazeutischer Wirkstoffe eingesetzt. Die Materialien sind z.B. dünne, leichte und biegsame Filme aus modifizierter Stärke. Sie sind ein- oder mehrschichtig aufgebaut, wobei mindestens eine Schicht den Wirkstoff aufnimmt. Diese blatt- oder folienartigen Materialien sind beispielsweise wasserlöslich. Bei der Applikation am Menschen, z.B. auf der Zunge, lösen sie sich auf und geben den Wirkstoff frei.

Um ein Austrocknen zu vermeiden, werden diese blatt- und folienartigen Materialien in der Regel einzeln verpackt. Zum Verpacken wird ein einzelnes blatt- oder folienartiges Material zwischen zwei Packstoffbahnen eingesetzt und die Packstoffbahnen beispielsweise zur Bildung eines Vierrandsiegelbeutels miteinander verschweißt. Beim Einsetzen des einzelnen blatt- oder folienartigen Materials zwischen die Packstoffbahnen genügt schon ein leichter Luftzug, um die Lage des Materials zu verändern oder um es aus dem Bereich der Packstoffbahnen zu wehen. Erst nach dem Versiegeln z.B. des einzelnen Vierrandsiegelbeutel kann festgestellt werden, ob ein blatt- oder folienartige Material sich überhaupt in dem Vierransiegelbeutel befindet.

Als Träger pharmazeutischer Produkte können die blatt- oder folienartigen Materialien kennzeichnungspflichtig sein. Eine derartige Kennzeichnung dient z.B. der Identifizierung der Art, der Charge und/oder des einzelnen blatt- oder folienartigen Materials. Beim Aufbringen der Kennzeichnung darf das blatt- oder folienartige Material nicht angegriffen werden. Eine wasserlösliche oder lösungsmittelhaltige Kennzeichnung kommt daher nicht in Frage, denn durch das Wasser oder das Lösungsmittel würde die Wirkstoffkonzentration des blatt- oder folienartigen Materials verändert werden.

Der vorliegenden Erfindung liegt die Problemstellung zugrunde, ein betriebssicheres automatisiertes Verpackungs- und Kennzeichnungsverfahren für blatt- oder folienartige Materialien zu entwickeln.

Diese Problemstellung wird mit den Merkmalen des Hauptanspruches gelöst. Dazu wird eine Kennzeichnung aus einem wachsartigen Kennzeichnungswerkstoff auf eine erwärmte erste Packstoffbahn aufgebracht. Das blatt- oder folienartige Material wird mit einer Oberfläche, deren Rauhigkeit größer ist als die Rauhigkeit der Oberfläche der ersten Packstoffbahn, auf der die Kennzeichnung haftet, auf der Kennzeichnung fixiert. Eine zweite Packstoffbahn wird über das blatt- oder folienartige Material gelegt wird und mit der ersten Packstoffbahn zur Bildung einer geschlossenen Verpackungseinheit verbunden. Die Verpackungseinheit wird gekühlt, wobei sich die Kennzeichnung von der ersten Packstoffbahn löst.

Wachsartige Werkstoffe sind organische Stoffe. Sie sind z.B. bei einer Raumtemperatur von 20°C zäh bis hart. Bei steigenden Temperaturen werden sie plastisch verformbar. Bei Temperaturen über beispielsweise 40°C sind sie schmelzbar, wobei die Viskosität der Schmelze mit zunehmender Temperatur abnimmt. Wachsartige Werkstoffe sind beispielsweise natürlich vorkommende Tier- oder Pflanzenwachse wie z.B. das Bienenwachs und künstliche Wachse, z.B. Gemische fester Paraffine.

Bei der Aufbringung der Kennzeichnung aus einem wachsartigen Werkstoff wird flüssiges, zähflüssiges oder festes Wachs auf die erwärmte erste Packstoffbahn aufgebracht. Der Auftrag erfolgt z.B. durch Besprühen aus einer festen oder beweglichen Düse mit oder ohne Schablone, durch einen Wachsstift, etc. Beim Auftragen eines flüssigen Wachses verhindert die erwärmte erste Packstoffbahn ein Erstarren des Wachses. Wird ein festes Wachs aufgetragen, wird es durch die erwärmte Packstoffbahn zumindest in den zähen Zustand erwärmt.

Die Oberfläche der Packstoffbahn hat eine geringe Rauhigkeit. Das Wachs haftet daher mit geringer Affinität an der Packstoffbahn.

Zum Fixieren des blatt- oder folienartigen Materials auf dem Kennzeichen wird das blatt- oder folienartige Material mit einer rauen Oberfläche auf das Kennzeichen aufgesetzt. Die beiden Teile haften mit hoher Affinität aneinander. Beispielsweise kann ein Luftzug die Lage des blatt- oder folienartigen Materials zur Packstoffbahn nicht verändern.

Im nächsten Verfahrensschritt wird die zweite Packstoffbahn über das blatt- oder folienartige Material übergelegt und die beiden Packstoffbahnen z.B. mittels einer Siegelrandverschweißung verschweißt. Das blatt- oder folienartige Material ist weiterhin auf dem Kennzeichen fixiert, das an der ersten Packstoffbahn haftet.

Die so hergestellte Verpackungseinheit wird nun gekühlt. Hierbei erstarrt das Wachs. Es löst sich von der Oberfläche der ersten Packstoffbahn, haftet jedoch weiterhin an der Oberfläche des blatt- oder folienartigen Materials. Hierdurch wird die Kennzeichnung auf das blatt- oder folienartige Material übertragen.

Nach Beendigung des Verfahrens enthält jede Verpackungseinheit ein gleichmäßig positioniertes, gekennzeichnetes blatt- oder folienartiges Material.

Diese Verfahrensschritte ermöglichen somit eine automatisierte Verpackung und Kennzeichnung blatt- oder folienartiger Materialien.

Weitere Einzelheiten der Erfindung ergeben sich aus den Unteransprüchen und der nachfolgenden Beschreibung einer schematisch dargestellten Ausführungsform.

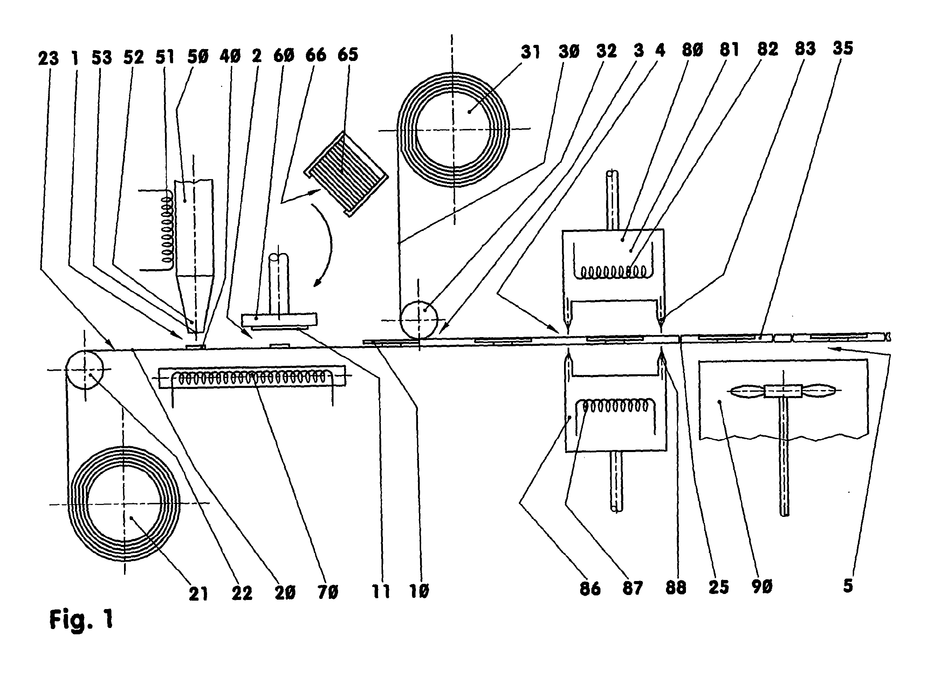

- Figur 1:: Verfahren zur Verpackung und Kennzeichnung blatt- oder folienartiger Materialien.

Die Figur 1 zeigt ein Verfahren zur Verpackung und Kennzeichnung blatt- oder folienartiger Materialien (10). Die blatt- oder folienartigen Materialien (10) sind beispielsweise Wafer (10). Dies sind wasserlösliche, dünne Filme aus modifizierter Stärke, die einen pharmazeutischen Wirkstoff enthalten. Die Abmessungen eines Wafers (10) betragen z.B. etwa 20 x 30 mm.

Das Verfahren umfasst beispielsweise fünf Schritte (1 - 5). In einem ersten Verfahrensschritt (1) wird auf eine erste, untere Packstoffbahn (20) z.B. mittels eines Sprühgeräts (50) eine Kennzeichnung (40) aufgebracht.

Im zweiten Verfahrensschritt (2) wird der Wafer (10), der beispielsweise mittels eines Sauggreifers (60) aus einem Magazin (65) an die erste Packstoffbahn (20) gefördert wird, auf die Kennzeichnung (40) aufgesetzt. Die erste Packstoffbahn (20) wird während des Aufbringens der Kennzeichnung (40) und dem Aufsetzen des Wafers (10) z.B. mittels einer Heizung (70) auf beispielsweise etwa 40°C erwärmt.

Im nächsten Verfahrensschritt (3) wird eine zweite, beispielsweise obere Packstoffbahn (30) auf den Wafer (10) und die untere Packstoffbahn (20) aufgelegt.

Mit einem Siegelgerät (80) werden im vierten Verfahrensschritt (4) um den Wafer (10) herum die beiden übereinanderliegenden Packstoffbahnen (20, 30) mit z.B. vier Siegelnähten (25) verbunden. Damit wird als Verpackungseinheit (35) beispielsweise ein allseits geschlossener Vierrand-Siegelbeutel (35) hergestellt, in dem genau ein Wafer (10) verpackt ist.

Die Vierrand-Siegelbeutel (35) werden im nächsten Verfahrensschritt (5) beispielsweise von ihrer Unterseite mittels eines Kühlgerätes (90) gekühlt.

Die untere Packstoffbahn (20) ist beispielsweise eine transparente Kunststofffolienbahn, z.B. aus Polyäthylen. Zumindest die obenliegende Oberfläche (23) dieser Packstoffbahn weist eine geringe Rauhigkeit auf, sie ist also weitgehend glatt. Gegebenenfalls kann sie auch mit Silikon beschichtet sein.

Die untere Packstoffbahn (20) wird von einer Trommel (21) abgewickelt und über eine Umlenkrolle (22) geführt. Beispielsweise durch eine radiale Verstellung der Umlenkrolle (22) wird die Packstoffbahn (20) ausgerichtet und gespannt.

Auf die obenliegende Oberfläche (23) der mittels der Heizung (70) erwärmten Packstoffbahn (20) wird im ersten Verfahrensschritt (1) das Kennzeichen (40) aufgebracht. Das Kennzeichen (40) ist aus einem wachsartigen Werkstoff, beispielsweise Bienenwachs. Es kann transparent oder gefärbt sein.

Das Bienenwachs wird vor der Aufbringung z.B. im Sprühgerät (50) mit einer Heizung (51) auf eine Temperatur von beispielsweise 80°C erhitzt. Bei dieser Temperatur ist es flüssig und hat eine niedrige Viskosität. Beispielsweise innerhalb des Sprühgeräts (50) wird das Bienenwachs zu einem Sprühkopf (52) gefördert. Dieser Sprühkopf (52) umfasst beispielsweise eine Schablone und eine Düse (53), durch die das Bienenwachs auf die Packstoffbahn (20) geleitet wird. Hierbei bildet sich z.B. das Bild der Schablone auf der Packstoffbahn (20) ab. Das als Kennzeichnung (40) aufgebrachte Bienenwachs kann ein- oder mehrfarbig sein. Die Kennzeichnung (40) kann z.B. eine alphanumerische, ein digitale, eine farbkodierte Zeichenfolge umfassen.

Der Sprühkopf (52) und/oder die Düse (53) kann fest oder beweglich sein. Ein beweglicher Sprühkopf (52) und/oder eine bewegliche Düse (53) kann beispielsweise rechnergestützt angesteuert sein, so dass z.B. später jeder einzelne Wafer (10) eine individuelle Kennzeichnung (40) erhält. Beim Einsatz eines beweglichen Sprühkopfes (52) und/oder einer beweglichen Düse (53) kann z.B. auf eine Schablone verzichtet werden.

Das Sprühgerät (50) kann mehrere Sprühköpfe (52) und/oder Düsen umfassen. Diese können fest oder beweglich sein. Am oder im Sprühgerät (40) kann auch eine Reinigungsvorrichtung beispielsweise zur Reinigung der Düse (53) angeordnet sein.

Beim Auftreffen des heißen Bienenwachses auf der Oberfläche (23) der erwärmten Packstoffbahn (20) wird das Bienenwachs abgekühlt. Da jedoch die Temperatur der Packstoffbahn (20) höher ist als die Erstarrungstemperatur des Bienenwachses, bleibt dieses zähflüssig. Es haftet an der zumindest weitgehend glatten Oberfläche (23) der Packstoffbahn (20). Die Kennzeichnung (40) ist nun z.B. von der Unterseite der Packstoffbahn (20) lesbar.

Nach dem Aufbringen der Kennzeichnung (40) wird die erwärmte Packstoffbahn (20) zur Bestückung (2) mit dem einzelnen Wafer (10) weitergefördert. Auch bei der Bestückung (2) kann die Packstoffbahn (20) durch die Heizung (70) erwärmt werden.

Der einzelne Wafer (10) hat zumindest eine Oberfläche (11) auf, deren Rauhigkeit größer ist als die Rauhigkeit der Oberfläche (23) der Packstoffbahn (20). Im Magazin (65) sind die Wafer (10) beispielsweise derart gestapelt, dass diese rauen Oberflächen (11) von der Entnahmeseite (66) des Magazins (65) abgewandt sind.

Zur Entnahme des Wafers (10) aus dem Magazin (65) wird beispielsweise der Sauggreifer (60) vor dem Magazin (65) positioniert. Durch Einschalten des Unterdrucks wird der erste im Magazin (65) liegende Wafer (10) angesaugt und aufgenommen. Der Sauggreifer (60) schwenkt nun beispielsweise in eine Position oberhalb der Packstoffbahn (20) und verfährt axial in Richtung der Packstoffbahn (20). Sobald der Wafer (10) die Kennzeichnung (40) berührt, wird der Unterdruck abgeschaltet. Der Wafer (10) löst sich vom Sauggreifer (60) und haftet mit der rauen Oberfläche (11) auf der Kennzeichnung (40).

Die bestückte Packstoffbahn (20) wird nun getaktet zur Aufbringung (3) der oberen Packstoffbahn (30) weitergefördert.

Die obere Packstoffbahn (30) kann aus dem gleichen Werkstoff bestehen wie die untere Packstoffbahn (20). Sie läuft von einer Trommel (31) ab. Beispielsweise mittels einer Umlenkrolle (32) wird die obere Packstoffbahn (30) ausgerichtet und gespannt. Die beiden Packstoffbahnen (20, 30) werden z.B. mit einem gemeinsamen Antrieb gefördert. Sie werden dann mit identischer Taktfrequenz und gleichem Takthub bewegt.

Beim nächsten Takt, die Taktfrequenz beträgt beispielsweise 100 Takte pro Minute, werden die Packstoffbahnen (20, 30) mit dem Wafer (10) zur Versiegelung (4) unter das Siegelgerät (80) gefördert.

Das Siegelgerät (80) umfasst beispielsweise ein oberes (81) und ein unteres Siegelgerätteil (86). Beide (81, 86) umfassen z.B. Siegelheizungen (82, 87), mit denen Siegelleisten (83, 88) erwärmt werden. In der Figur 1 sind nur jeweils zwei Siegelleisten (83, 88) pro Siegelgerätteil (81, 86) für quer zur Förderrichtung orientierte Siegelnähte (25) dargestellt. Selbstverständlich können auch zusätzliche Siegelleisten beispielsweise für Siegelnähte in Förderrichtung vorgesehen sein. Zum Versiegeln (4) werden die Siegelgerätteile (81, 86) aufeinander zu bewegt und verschweißen dabei die zwischen ihnen liegenden Packstoffbahnen (20, 30) miteinander. Hierbei beträgt die Schweißdauer beispielsweise 1/160 Sekunde. Um den Wafer (10) herum werden so beispielsweise vier Siegelnähte (25) erzeugt. Der Wafer (10) ist nun in einer Verpackungseinheit (35), z.B. einem Vierrand-Siegelbeutel (35), verpackt. Die einzelnen Verpacküngseinheiten (35) sind miteinander verbunden und werden gemeinsam zur Kühlung (5) weitergefördert.

Bei der Kühlung (5) werden die Vierrand-Siegelbeutel (35) mittels des beispielsweise unterhalb des Fördergutes (20, 30, 35) angeordneten Kühlgeräts (90) z.B. auf eine Raumtemperatur von 20°C gekühlt. Das Bienenwachs erstarrt nun vollständig. Es löst sich von der Oberfläche (23) der unteren Packstoffbahn (20). Es bleibt aber weiterhin an der raueren Oberfläche (11) des Wafers (10) haften. Die Kennzeichnung (40) ist so auf den Wafer (10) übertragen.

Bei diesem Verfahren wird die Substanz des Wafers (10) nicht verändert. Der Wafer (10) behält seine Wirkstoffkonzentration und seinen Feuchtigkeitsgehalt bei.

### Bezugszeichenliste:

- 1: erster Verfahrensschritt, Kennzeichnung
- 2: zweiter Verfahrensschritt, Bestückung
- 3: dritter Verfahrensschritt, Aufbringen der oberen Packstoffbahn
- 4: vierter Verfahrensschritt, Versiegelung
- 5: fünfter Verfahrensschritt, Kühlung

- 10: blatt- oder folienartiges Material, Wafer
- 11: Oberfläche

- 20: erste Packstoffbahn, untere Packstoffbahn
- 21: Trommel
- 22: Umlenkrolle
- 23: Oberfläche

- 25: Siegelnähte

- 30: zweite Packstoffbahn, obere Packstoffbahn
- 31: Trommel
- 32: Umlenkrolle

- 35: Verpackungseinheit, Vierrand-Siegelbeutel

- 40: Kennzeichnung

- 50: Sprühgerät
- 51: Heizung
- 52: Sprühkopf
- 53: Düse

- 60: Sauggreifer
- 65: Magazin
- 66: Entnahmeseite

- 70: Heizung

- 80: Siegelgerät
- 81: oberes Siegelgerätteil
- 82: Siegelheizung
- 83: Siegelleisten

- 86: unteres Siegelgerätteil
- 87: Siegelheizung
- 88: Siegelleisten

- 90: Kühlgerät

## Patentansprüche

1. Verfahren zur automatisierten Einzelverpackung blatt- oder folienartiger Materialien, die aus mindestens einer Materialschicht bestehen, in eine Verpackungseinheit mit kennzeichentragendem Inhalt,
- wobei eine Kennzeichnung (40) aus einem wachsartigen Kennzeichnungswerkstoff auf eine erwärmte erste Packstoffbahn (20) aufgebracht wird,
- wobei das blatt- oder folienartige Material (10) mit einer Oberfläche (11), deren Rauhigkeit größer ist als die Rauhigkeit der Oberfläche (23) der ersten Packstoffbahn (20), auf der die Kennzeichnung (40) haftet, auf der Kennzeichnung (40) fixiert wird,
- wobei eine zweite Packstoffbahn (30) über das blatt- oder folienartige Material (10) gelegt wird und mit der ersten Packstoffbahn (20) zur Bildung einer geschlossenen Verpackungseinheit (35) verbunden wird,
- wobei die Verpackungseinheit (35) gekühlt wird und sich dabei die Kennzeichnung (40) von der ersten Packstoffbahn (20) löst.

2. Verfahren nach Anspruch 1, **dadurch gekennzeichnet, dass** die erste Packstoffbahn (20) während des Aufbringens der Kennzeichnung (40) und der Fixierung des blatt- oder folienartigen Materials (10) erwärmt wird.

3. Verfahren nach Anspruch 1, **dadurch gekennzeichnet, dass** der Kennzeichnungswerkstoff ein Bienenwachs ist.

4. Verfahren nach Anspruch 1, **dadurch gekennzeichnet, dass** die blatt- oder folienartige Materialien (10) wasserlöslich sind.

5. Verfahren nach Anspruch 1, **dadurch gekennzeichnet, dass** die blatt- oder folienartiger Materialien (10) in einen Vierrand-Siegelbeutel (35) verpackt werden.

## Claims

1. A method for individually packing sheet- or film-like materials in an automatic manner, said materials consisting of at least one material layer, in a packing unit with marked contents,
- a marking (40) made of a waxy marking material being applied to a heated first packing material strip (20),
- the sheet- or film-like material (10) being fixed on the marking (40) with a surface (11) of a roughness greater than the roughness of the surface (23) of the first packing material strip (20), on which the marking is adhesively attached,
- a second packing material strip (30) being placed over the sheet- or film-like material (10) and joined to the first packing material strip (20) to form a closed packing unit (35),
- the packing unit (35) being cooled and the marking (40) thereby coming away from the first packing material strip (20).

2. The method as claimed in claim 1, **characterized in that** the first packing material strip (20) is heated during the application of the marking (40) and the fixing of the sheet- or film-like material (10).

3. The method as claimed in claim 1, **characterized in that** the marking material is a beeswax.

4. The method as claimed in claim 1, **characterized in that** the sheet- or film-like materials (10) are water-soluble.

5. The method as claimed in claim 1, **characterized in that** the sheet- or film-like materials (10) are packed in a four-edge sealed bag (35).

## Revendications

1. Procédé pour l'emballage individuel automatisé de matériaux en forme de feuille ou de film, qui sont formés par au moins une couche de matière, dans une unité d'emballage dont le contenu porte un repère,
- une marque (40) dans un matériau du type cire étant appliquée sur une première bande de matériau d'emballage (20) chauffée,
- le matériau en forme de feuille ou de film (10) étant fixé sur la marque (40) avec une surface (11) dont la rugosité est supérieure à la rugosité de la surface (23) de la première bande de matériau d'emballage (20), sur laquelle adhère la marque (40),
- une deuxième bande de matériau d'emballage (30) étant posée au-dessus du matériau en forme de feuille ou de film (10) et étant assemblée à la première bande de matériau d'emballage (20) pour former une unité d'emballage (35) fermée,
- l'unité d'emballage (35) étant refroidie et le repérage (40) se détachant, à cette occasion, de la première bande de matériau d'emballage (20).

2. Procédé selon la revendication 1, **caractérisé en ce que** la première bande de matériau d'emballage (20) est chauffée pendant l'application de la marque (40) et la fixation du matériau en forme de feuille ou de film (10).

3. Procédé selon la revendication 1, **caractérisé en ce que** le matériau de la marque est une cire d'abeille.

4. Procédé selon la revendication 1, **caractérisé en ce que** les matériaux en forme de feuille ou de film (10) sont solubles à l'eau.

5. Procédé selon la revendication 1, **caractérisé en ce que** les matériaux en forme de feuille ou de film (10) sont emballés dans un sachet (35) scellé sur quatre bords.
